Europäisches Patentamt

European Patent Office

Office européen des brevets

(11) Publication number: **0 219 040**
**B1**

# EUROPEAN PATENT SPECIFICATION

(45) Date of publication of patent specification: **27.12.90**

(21) Application number: **86113860.0**

(22) Date of filing: **07.10.86**

(51) Int. Cl.⁵: **H 03 K 19/082,**
**H 03 K 19/0175,**
**H 03 K 19/013**

(54) **Circuit for the speeding-up of up-going transitions in TTL or DTL circuits under high capacitive load.**

(30) Priority: **18.10.85 US 789250**

(43) Date of publication of application:
**22.04.87 Bulletin 87/17**

(45) Publication of the grant of the patent:
**27.12.90 Bulletin 90/52**

(84) Designated Contracting States:
**DE FR GB IT**

(56) References cited:
**EP-A-0 069 853**
**DE-B-2 351 128**
**US-A-3 576 445**
**US-A-4 239 981**

**PATENT ABSTRACTS OF JAPAN, vol. 8, no. 250
(E-279)1687r, 16th November 1984 & JP-A-59-
126 325**

(73) Proprietor: **International Business Machines
Corporation
Old Orchard Road
Armonk, N.Y. 10504 (US)**

(72) Inventor: **Culican, Edward Francis
Marshall Road RR1, Box 323
Hyde Park New York (US)**
Inventor: **Pritzlaff, Philip Edward, Jr.
9, Tano Drive
Highland New York (US)**
Inventor: **van Goor, Kenneth Alan
Box 171-A Rural Road No. 1
Salt Point New York (US)**
Inventor: **Schettler, Helmut
Jägerstrasse 23
D-7405 Dettenhausen (DE)**

(74) Representative: **Rudack, Günter O., Dipl.-Ing.
IBM Corporation Säumerstrasse 4
CH-8803 Rüschlikon (CH)**

Courier Press, Leamington Spa, England.

## Description

The invention relates generally to circuits for digital equipment, and more particularly to a circuit for enhancing the ability of digital circuits to drive highly capacitive loads, especially for speeding up the up-going transitions occurring. The circuit in accordance with the invention has particular utility when employed with logic circuits such as "TTL" (Transistor-Transistor Logic) and "DTL" (Diode-Transistor Logic).

In the interconnection of voltage mode circuits such as TTL and DTL, it is probable that the circuits will be required to drive a high capacitance net. The high capacitance can be attributed to long lengths of interconnecting wires and the inputs of the loading gates. The speed of a down-going transition of the voltage mode circuit is dominated by the ability of the output transistor of the driving circuit to discharge the load capacitance. The speed of the up-going transition of the driving circuit is determined by the value of the output pull-up resistor. The value of the output pull-up resistor is usually optimized for the more common low capacitance load. Thus, the up-going transition speed of such a gate will be poor.

The up-going transition of TTL and DTL circuits employing passive pull-up circuit means (such as one or more transistors) is slow when applied to, or driving, a high capacitive load. This effect is a significant problem for VLSI chips.

A number of circuits directed to the rapid and/or controlled charge and/or discharge of a highly capacitive load, or line, are known in the art.

Among the most significant references is US—A—3 576 445 which discloses a circuit for speeding up the up-going transitions in TTL circuits under high capacitive load and coupled between the output of a plurality of binary logic circuits and a highly capacitive load circuit.

In particular, the speed-up circuit disclosed in US—A—3 576 445 includes an input terminal connected to the output of the plurality of binary logic circuits, an output terminal connected to the input of the highly capacitive load circuit, a transistor whose emitter is connected to the input terminal, and whose collector is connected to the output terminal of the speed-up circuit, a resistor connected between the base of the transistor and a source of potential, and a diode bridging the base-collector junction of said transistor.

Another reference of interest in this connection is US—A—4 239 981 in which a fast capacitance charging circuit is shown to utilize a small difference in forward bias drops across different kinds of Schottky diodes to clamp digital logic voltage swings.

The state of the art is further represented by EP—A—0 069 853 in which a TTL gate circuit is disclosed comprising an input transistor, an inverter transistor, an output transistor and a pull-up transistor. To achieve fast switching of the output transistor, a smaller amount of base current is applied to the inverter transistor than is applied to the base of the output transistor.

The invention may be summarized as a line charging, or speed-up, circuit the employment of which materially increases the speed with which a logic circuit, or the like, can drive, or charge-up a highly capacitive load. The "speed-up" circuit includes transistor circuit means for rapidly charging the capacitive load, and also transistor circuit means for isolating the input of the charging circuit from the output of the charging circuit during the up-going transition of an input signal, i.e. charging of the capacitive load. The charging circuit further includes means for aiding the discharge of the capacitive load during a down-level transition of an input signal.

The invention, accordingly, relates to a speed-up circuit in a circuitry for the speeding-up of up-going transitions in TTL or DTL circuits under high capacitive load, said circuitry being realized on an integrated circuit chip comprising a plurality of binary logic circuits, each having at least one input and an output, and a highly capacitive load circuit having at an input, said speed-up circuit having its input coupled to a common connection of the outputs of said plurality of binary logic circuits and its output connected to said input of said highly capacitive load circuit. The speed-up circuit is characterized in that it comprises first, second, third and fourth transistors each having an emitter, a base and a collector, and first and second resistors, that the collector and the base of said second transistor and the base of said third transistor are connected in common, that the second resistor is connected between a source of potential and the collector of said second transistor, that the first resistor is connected between said source of potential and a common connection of the emitter and said base of said fourth transistor and the base of said first transistor, that the emitter of said second transistor and the emitter of said first transistor are connected in common to form the input of the speed-up circuit, which is connected to the outputs of said binary logic circuits, that the collector of said third transistor is connected to said source of potential, and that the emitter of said third transistor, the collector of said fourth transistor and the collector of said first transistor are connected in common to form the output of the speed-up circuit which is connected to said input of said highly capacitive load circuit.

The features and advantages of the invention will be apparent from the following more particular description of a preferred embodiment of the invention as illustrated in the accompanying drawings, in which

Fig. 1 is a schematic diagram of the line charger or speed-up circuit in accordance with the invention.

Fig. 2 is a block diagram of the line charger as employed in a typical logic gate configuration. It should be noted that the maximum benefit of the line charger is achieved when the line charger is physically located near the driving circuits. The capacitor pictured on the output of the line charger represents the land capacitance of the metal connecting the output of the driving circuits to the input of the load circuits.

Fig. 3 discloses the simulated block diagram circuits employed to determine the delta in switching speed provided by the line charger.

Figure 4 discloses a plot showing the simulated response of TTL gates A and B (Figure 3) to a falling transition. TTL gate B responded in a time t. TTL gate A in cooperation with the line charger responded in a time 0.3t.

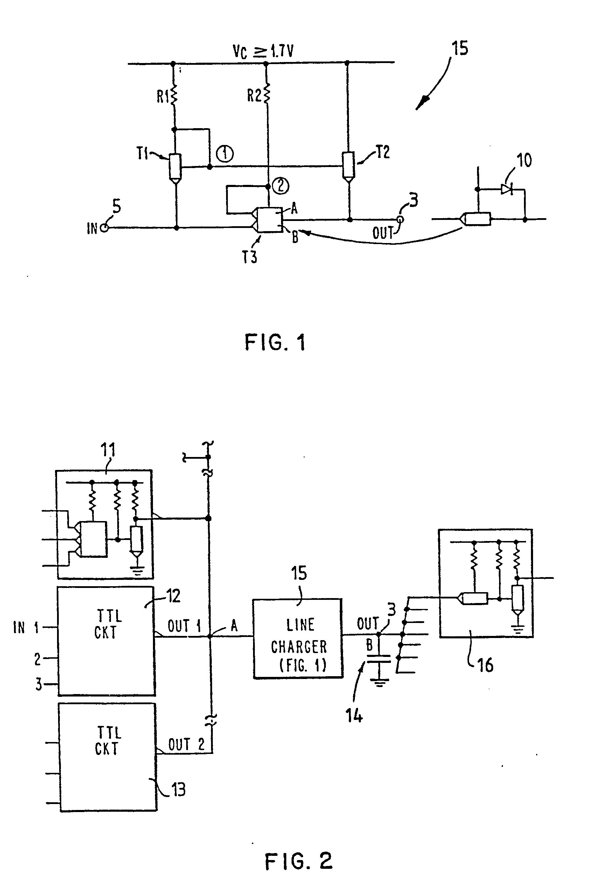

The up-going transition of TTL or DTL circuits is slow when applied to a high capacitive load. This effect turns out to be a major problem for VLSI logic chips. The circuit shown in figure 1 is an active pull-up circuit 15 to be connected between the output of the driving circuit 11, 12, 13 and its load 14 and the logic circuits 16 and connected to output node 3, as shown in figure 2. Capacitive load 14 may comprise the capacitance of the wiring as well as the input capacitance of said logic circuits. The operation of the speed-up circuit is as follows: With the output of the TTL gate 11, 12, 13 in figure 2 at a down level, the base-to emitter diode formed by transistor T1 will be forwarded biased clamping the voltage at node 1 to a level $V_{BE}$ above the input voltage. Likewise, the base-to-emitter junction of transistor T3B will be forward biased by a diode 10 causing it to operate in the saturated mode. In order to reduce the base-to-collector voltage of transistor T3B in the saturated mode, the base-to collector voltage of transistor T3B is integrated in parallel. The relation of the output voltage to the input voltage will be governed by the collector-to-emitter saturation voltage ($V_{CE\ SAT}$) of transistor T3B. Transistor T2 will not be conducting current in this mode since the voltage from node 1 to the output node 3 is not great enough to forward bias the base-to-emitter junction of transistor T2.

The operation of the Line Charger 15 of figure 1, while stimulated by an up-going transition is as follows:

The voltage at node 1 will rise along with the input voltage. The rising voltage at node 1 will activate transistor T2. The current conducted from collector to emitter of transistor T2 will charge the load capacitance 14 connected to the output node 3. Transistor T3B isolates the effect of the load capacitance at output node 3 from input 5 during this transition.

With the input 5 at the 'up' state, the circuit operation is as follows: The input voltage, node 1 and node 2 will have risen to the level of supply voltage to $V_C$. Transistors T1, T3A and T3B will be inactive. Transistor T2 will be forward biased clamping the output voltage to a level $V_{BE}$ below the supply voltage $V_C$.

During the input falling transition transistors T1 and T3B are forward biased and transistor T2 becomes inactive. With transistor T3B active, the load capacitance at output node 3 is discharged and the output voltage falls to the low state.

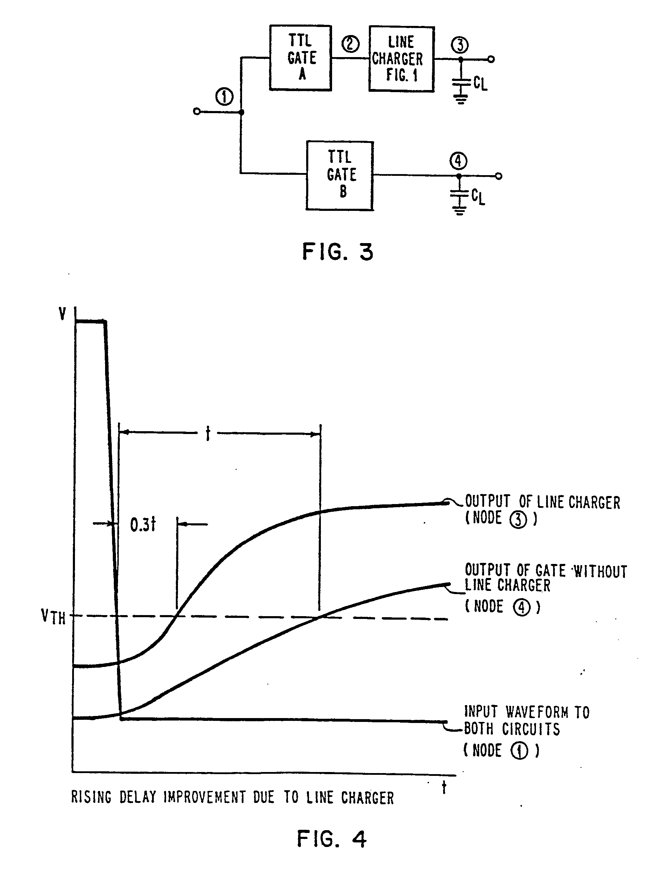

The circuit shown in figure 3 was simulated in order to compare the switching speed of a TTL gate with the aid of a line charger (gate A) and of a TTL gate without the aid of a line charger (gate B). The voltage at node 4, the output voltage of gate B, figure 4, rose to the threshold voltage in a time t after having been stimulated by the input voltage at node 1. The output voltage of the line charger at node 3, figure 3, responded to the input stimulus in a time 03t. Transistor T2 charges the capacitive load 14 very rapidly. Transistor T3B isolates the capacitive load 14 on the output node 3 from the input 5, during the up-going transistor. Transistor T1 and resistor R1 transfer the fast up-going transition of the input voltage to the base of the driving transistor T2. The 'line charger' 15 is placed physically close to the driving TTL gate. Therefore, the input to the 'line charger' is only slightly loaded and fast. During the down-level, transistor T3B is on and connects the output node 3 to the input 5. Summarizing, the 'line charger' circuit has an active up-going transition supported by transistor T2, and an active down-going transition of the TT1. circuit provided by transistor T3B. Diode-connected transistor T3A is used to reduce the inverse current in transistor T3B during the saturation thereof.

**Claim**

Speed-up circuit (15) in a circuitry for the speeding-up of up-going transitions in TTL or DTL circuits under high capacitive load, said circuitry being realized on an integrated circuit chip comprising a plurality of binary logic circuits (11, 12, 13), each having at least one input and an output, and a highly capacitive load circuit (14) having an input (B), said speed-up circuit (15) having its input (5) coupled to a common connection (A) of the outputs of said plurality of binary logic circuits (11, 12, 13) and its output (3) connected to said input (B) of said highly capacitive load circuit (14), characterized in

that it comprises first, second, third and fourth transistors (T3B, T1,T2, T3A) each having an emitter, a base and a collector, and first and second resistors (R2, R1),

that the collector and the base of said second transistor (T1) and the base of said third transistor (T2) are connected in common (1),

that the second resistor (RI) is connected between a source of potential ($V_c$) and the collector of said second transistor (T1),

that the first resistor (R2) is connected between said source of potential ($V_c$) and a common connection (2) of the emitter and said base of said fourth transistor (T3A) and the base of said first transistor (T3B),

that the emitter of said second transistor (T1) and the emitter of said first transistor (T3B) are connected in common to form the input (5) of the speed-up circuit (15), which is connected to the outputs of said binary logic circuits (11, 12, 13),

that the collector of said third transistor (T2) is connected to said source of potential ($V_c$), and

that the emitter of said third transistor (T2), the collector of said fourth transistor (T3A) and the collector of said first transistor (T3B) are connected in common (3) to form the output of the speed-up circuit (15), which is connected to said input (B) of said highly capacitive load circuit (14).

**Patentanspruch**

Schaltung (15) zum Beschleunigen der ansteigenden Übergäge in TTL- oder DTL-Schaltungen mit hoher kapazitiver Last, wobei die Schaltung auf einem integrierten Schaltungs-Chip realisiert ist, der eine Vielzahl von binären logischen Schaltungen (11, 12, 13) aufweist, die je wenigstens einen Eingang und einen Ausgang haben sowie einen Schaltkreis (14) mit hoher kapazitiver Last und einem Eingang (B), wobei der Eingang (5) der Schaltung (15) an eine gemeinsame Verbindung (A) der Ausgänge der genannten Vielzahl von binären logischen Schaltungen (11, 12, 13) und ihr Ausgang (3) an den genannten Eingang (B) des Schaltkreises (14) mit hoher kapazitiver Last angeschlossen sind, dadurch gekennzeichnet, daß

sie erste, zweite, dritte und vierte Transistoren (T3B, T1, T2, T3A) aufweist, die einen Emitter, eine Basis und einen Kollektor haben, sowie erste und zweite Widerstände (R2, R1),

daß der Kollektor und die Basis des genannten zweiten Transistors (T1) und die Basis des genannten dritten Transistors (T2) miteinander verbunden sind (1),

daß der zweite Widerstand (R1) zwischen der Spannungsquelle (V$_c$) und dem Kollektor des genannten zweiten Transistors (T1) liegt,

daß der erste Widerstand (R2) zwischen der genannten Spannungsquelle (V$_c$) und einer gemeinsamen Verbindung (2) des Emitters und der genannten Basis des vierten Transistor (T3A) und der Basis des genannten ersten Transistors (T3B) liegt,

daß der Emitter des genannten zweiten Transistors (T1) und der Emitter des ersten Transistors (T3B) miteinander verbunden sind und den Eingang (5) der Beschleunigungsschaltung (15) bilden, die mit den Ausgängen der genannten binären logischen Schaltungen (11, 12, 13), verbunden ist,

daß der Kollektor des genannten dritten Transistors (T2) mit der genannten Spannungsquelle (V$_c$) verbunden ist, und

daß der Emitter des genannten dritten Transistors (T2), der Kollektor des genannten vierten Transistors (T3A) und der Kollektor des genannten ersten Transistors (T3B) miteinander verbunden (3) sind, und den Ausgang der Beschleunigungsschaltung (15) bilden, der an den genannten Eingang (B) der Schaltung mit hoher kapazitiver Last (14) angeschlossen ist.

**Revendication**

1. Circuit d'accélération (15) dans un circuit pour l'accélération de transitions montantes dans des circuits TTL ou DTL sous charge capacitive élevée, ce circuit étant réalisé sur une puce de circuit intégré comprenant une pluralité de circuits logiques binaires (11, 12, 13) ayant chacun au moins une entrée et une sortie, et un circuit de charge très capacitif (14) ayant une entrée (B), ce circuit d'accélération (15) ayant son entrée (5) couplée à une connexion commune (A) des sorties de la pluralité de circuits logiques binaires (11, 12, 13) et sa sortie (3) connectée à l'entrée (B) du circuit de charge très capacitif (14), caractérisé en ce que:

il comprend des premier, second, troisième et quatrième transistors (T3B, T1, T2, T3A) ayant chacun un émetteur, une base et un collecteur, et des première et seconde résistances (R2, R1),

le collecteur et la base du second transistor (T1) et la base du troisième transistor (T2) sont interconnectés (1),

la seconde résistance (R1) est connectée entre une source de potentiel (V$_c$) et le collecteur du second transistor (T1),

la première résistance (R2) est connectée entre la source de potentiel (V$_c$) et une connexion commune (2) de l'émetteur et de la base du quatrième transistor (T3A) et la base du premier transistor (T3B),

l'émetteur du second transistor (T1) et l'émetteur du premier transistor (T3B) sont connectés ensemble pour former l'entrée (5) du circuit d'accélération (15), qui est connectée aux sorties des circuits logiques binaires (11, 12, 13),

le collecteur du troisième transistor (T2) est connecté à la source de potentiel (V$_c$), et

l'émetteur du troisième transistor (T2), le collecteur du quatrième transistor (T3A) et le collecteur du premier transistor (T3B) sont connectés ensemble (3) pour former la sortie du circuit d'accélération (15) qui est connectée à l'entrée (B) du circuit de charge très capacitif (14).

$V_C \geq 1.7V$

15

R1    R2

T1    ①

②

T3    A

IN  5        B

3

OUT

10

FIG. 1

11

12
TTL
CKT

IN 1

2

3

OUT 1    A

15

LINE
CHARGER
(FIG. 1)

OUT  3

B

14

16

13
TTL
CKT

OUT 2

FIG. 2

1

FIG. 3

OUTPUT OF LINE CHARGER
(NODE ③)

OUTPUT OF GATE WITHOUT
LINE CHARGER
(NODE ④)

INPUT WAVEFORM TO
BOTH CIRCUITS
(NODE ①)

RISING DELAY IMPROVEMENT DUE TO LINE CHARGER

FIG. 4

2